# EUROPEAN PATENT APPLICATION

(11) **EP 2 482 307 A1**
(43) Date of publication of application: **01.08.2012**
(21) Application number: 10818752.7
(22) Date of filing: 17.09.2010
(51) Int. Cl.: H01L 21/20, H01L 21/336, H01L 29/12, H01L 29/78

(54) **SILICON CARBIDE INGOT, SILICON CARBIDE SUBSTRATE, METHODS FOR MANUFACTURING THE INGOT AND THE SUBSTRATE, CRUCIBLE, AND SEMICONDUCTOR SUBSTRATE**

(30) Priority: 24.09.2009 JP 2009219065; 15.03.2010 JP 2010057904
(71) Applicant: Sumitomo Electric Industries, Ltd., Osaka-shi, Osaka 541-0041 (JP)
(72) Inventor: SASAKI, Makoto, Itami-shi Hyogo 664-0016 (JP); HARADA, Shin, Osaka-shi Osaka 554-0024 (JP); NISHIGUCHI, Taro, Itami-shi Hyogo 664-0016 (JP); OKITA, Kyoko, Itami-shi Hyogo 664-0016 (JP); INOUE, Hiroki, Itami-shi Hyogo 664-0016 (JP); NAMIKAWA, Yasuo, Itami-shi Hyogo 664-0016 (JP); FUJIWARA, Shinsuke, Itami-shi Hyogo 664-0016 (JP)
(74) Representative: Grünecker, Kinkeldey, Stockmair & Schwanhäusser
(86) International application number: PCT/JP2010/066155
(87) International publication number: WO 2011/037079

(57) **Abstract**

An SiC ingot (10a) includes a bottom face (12a) having 4 sides; four side faces (12b, 12c, 12d, 12e) extending from the bottom face (12a) in a direction intersecting the direction of the bottom face (12a); and a growth face (12f) connected with the side faces (12b, 12c, 12d, 12e), located at a side opposite to the bottom face (12a). At least one of the bottom face (12a), the side faces (12b, 12c, 12d, 12e), and the growth face (12f) is the {0001} plane, {1-100} plane, {11-20} plane, or a plane having an inclination within 10° relative to these planes.

## Description

### TECHNICAL FIELD

The present invention relates to a silicon carbide (SiC) ingot, an SiC substrate, a method for manufacturing an SiC ingot, a method for manufacturing an SiC substrate, a crucible, and a semiconductor substrate.

### BACKGROUND ART

In recent years, SiC substrates have been adopted as semiconductor substrates for use in manufacturing semiconductor devices. SiC has a band gap larger than that of Si (silicon), which has been used more commonly. Hence, a semiconductor device employing an SiC substrate advantageously has a large withstand voltage, low on-resistance, or have properties less likely to decrease in a high temperature environment.

In order to efficiently manufacture such semiconductor devices, the substrates need to be large in size to some extent. According to US Patent No. 7314520 (Patent Literature 1), an SiC substrate of 76 mm (3 inches) or greater can be manufactured.

### CITATION LIST

### PATENT LITERATURE

PTL 1: US Patent No. 7314520

### SUMMARY OF INVENTION

### TECHNICAL PROBLEM

In the case where an SiC substrate of a relatively large size such as that disclosed in the aforementioned Patent Literature 1 is to be manufactured, there are the following problems.

An SiC substrate with little defect is manufactured by being sliced from an SiC ingot of substantially a cylindrical shape (substantially circular when viewed from the growth face) obtained corresponding to the growth at the (0001) plane less susceptible to stacking defect. Therefore, in the case where a rectangular SiC substrate with the (0001) plane as the main surface is to be manufactured, the SiC substrate will be cut out substantially parallel to the growth face. This means that the portion other than the inscribed rectangular region in the SiC ingot will not be used for the SiC substrate, which is a waste of the SiC ingot. In other words, the waste in the SiC ingot is appreciable when an SiC substrate is produced from such an SiC ingot. This leads to the problem of cost in manufacturing an SiC substrate.

Moreover, in the above-described case, the processing of an SiC substrate having a rectangular main surface from an SiC ingot of a cylindrical shape is burdensome. The burdensome procedure leads to the problem of cost for manufacturing an SiC substrate.

The present invention is directed to the problems set forth above, and an object is to provide an SiC ingot, a manufacturing method thereof, and a crucible, allowing reduction in the cost of manufacturing an SiC substrate. Another object of the present invention is to provide an SiC substrate, a manufacturing method thereof, and a semiconductor substrate, allowing reduction in cost.

### SOLUTION TO PROBLEM

A silicon carbide (SiC) ingot of the present invention includes a bottom face having 4 sides, 4 side faces extending from the bottom face in a direction intersecting the extending direction of the bottom face, and a growth face connecting with the side faces, and located at a side opposite to the bottom face.

According to an SiC ingot of the present invention, an SiC ingot of substantially a rectangular solid is realized. By slicing the ingot in a direction parallel to or intersecting the bottom face, a quadrilateral SiC substrate can be manufactured. Since the plane orientation of the growth face and each of the 4 side faces differs from the plane orientation of the bottom face, an SiC substrate having a desired plane orientation for the main surface based on any of the side faces, bottom face, and growth face can be produced readily. For manufacturing an SiC substrate having a desired shape, a desired orientation, and the like, there can be manufactured an SiC ingot, allowing reduction in the material waste and reduction in the processing procedure. Thus, there can be realized an SiC ingot, allowing reduction in the cost in manufacturing an SiC substrate.

Preferably in the SiC ingot set forth above, at least one of the bottom face, side faces, and growth face is a {0001} plane, {1-100} plane, {11-20} plane, or a plane having an inclination within 10° relative to these planes.

Since an SiC substrate can be produced based on these planes, the manufacturing of an SiC substrate having a desired plane orientation and the like is facilitated. Thus, there can be realized an SiC ingot, allowing reduction in the cost in manufacturing an SiC substrate.

Preferably, the SiC ingot set forth above further includes a seed substrate formed in contact with the bottom face. The main surface of the seed substrate in contact with the bottom face corresponds to the {0001} plane, or has an inclination within 10° relative to this plane.

Even by an SiC ingot having a seed substrate, and crystal having the bottom face, side faces, and growth face formed on the seed substrate, waste in the material of the SiC ingot and the processing procedure can be reduced in manufacturing an SiC substrate. Further, since the main surface of the seed substrate has the plane orientation set forth above, the crystallinity of the SiC ingot can be rendered favorable.

An SiC substrate of the present invention is produced from the above-described SiC ingot. Since the SiC substrate of the present invention is produced based on any of the bottom face, the four side faces, or growth face of the SiC ingot, waste in the material of the ingot as well as the processing procedure can be reduced. Therefore, an SiC substrate can be manufactured with lower cost.

In a method for manufacturing the SiC substrate set forth above, the SiC substrate includes a main surface having an off angle greater than or equal to 50° and less than or equal to 65° relative to the {0001} plane. Accordingly, there can be manufactured an SiC substrate allowing higher channel mobility, as compared to the case where a device is produced on an SiC substrate having the main surface of the {0001} plane.

A crucible of the present invention includes a first portion, and a second portion. The first portion forms a region in which a raw material is disposed. The second portion is connected to the first portion, and forms a region in which a seed substrate is disposed to face the raw material. The cross sectional shape of the second portion is a quadrilateral or chamfered quadrilateral.

According to the crucible of the present invention, an SiC ingot can be grown by sublimating the material disposed in the first portion through heating to deposit material gas on the seed substrate disposed in the second portion. Since the second portion has a quadrilateral or chamfered quadrilateral sectional shape (horizontal cross section), the SiC ingot grown on the seed substrate can have a quadrilateral or chamfered quadrilateral cross section (plane shape in the horizontal direction). By using the crucible of the present invention, an SiC ingot of substantially a rectangular solid can be manufactured. Therefore, the SiC ingot manufactured using the crucible of the present invention allows reduction in the cost in manufacturing an SiC substrate, as set forth above.

Preferably in the crucible set forth above, the first and second portions are formed of graphite. Generation of a crack in the crucible can be suppressed since graphite is stable at high temperature. Moreover, since graphite is a constituent element of the SiC ingot, any graphite, if introduced into the SiC ingot due to sublimation of a portion of the crucible, will not act as impurities. Thus, the crystallinity of the manufactured SiC ingot can be rendered favorable.

A method for manufacturing an SiC ingot of the present invention is directed to a method for manufacturing a silicon carbide ingot using any of the crucibles set forth above. The method for manufacturing an SiC ingot of the present invention includes the steps of: disposing a raw material inside a first portion; disposing a seed substrate inside a second portion; and growing an SiC ingot by sublimation of the raw material through heating to deposit material gas on the seed substrate.

According to a method for manufacturing an SiC ingot of the present invention, an SiC ingot of substantially a rectangular solid can be manufactured since the crucible set forth above is used. Therefore, there can be manufactured an SiC ingot, allowing the cost to be reduced in manufacturing an SiC substrate, as set forth above.

Preferably in the method for manufacturing an SiC ingot set forth above, at least one of the four sides of the quadrilateral or chamfered quadrilateral for the cross sectional shape of the second portion in the crucible corresponds to the <0001> direction, <1-100> direction, <11-20> direction, or a direction having an inclination within 10° relative to these directions.

Since each side of the quadrilateral or chamfered quadrilateral of the second portion indicates the aforementioned direction in disposing the seed substrate in the second portion of the crucible, each side can play the role as an orientation flat, notch, or the like. Accordingly, an SiC ingot can be produced having the <0001> direction, <1-100> direction, <11-20> direction, or a direction having an inclination within 10° relative to these directions specified.

A method for manufacturing an SiC substrate of the present invention includes the steps of manufacturing an SiC ingot by the method for manufacturing an SiC ingot set forth above, and slicing an SiC substrate from the SiC ingot.

According to a method for manufacturing an SiC substrate of the present invention, an SiC substrate can be manufactured based on any of the bottom face, growth face, or four side faces of an SiC ingot. Therefore, waste in the material of the SiC ingot can be reduced. Also, the processing procedure can be reduced. Thus, an SiC substrate can be manufactured with the cost reduced.

Preferably in the slicing step of the method of manufacturing an SiC substrate set forth above, an SiC substrate is sliced from the SiC ingot using a wire saw. This facilitates manufacturing of an SiC substrate.

A semiconductor substrate of the present invention is obtained by aligning the SiC substrate set forth above in plurality on a same plane and combining the substrates.

The semiconductor substrate of the present invention has a large area as compared to each of a plurality of SiC substrates. A semiconductor device employing SiC can be manufactured more efficiently in the case where the SiC substrate set forth above is used for a semiconductor substrate, as compared to the case where each of the SiC substrate set forth above is employed solely. Thus, the cost can be reduced.

### ADVANTAGEOUS EFFECTS OF INVENTION

According to an SiC ingot, manufacturing method thereof, and crucible of the present invention, the cost in manufacturing an SiC substrate can be reduced. Further, according to an SiC substrate, manufacturing method thereof, and a semiconductor substrate of the present invention, the cost can be reduced.

### BRIEF DESCRIPTION OF DRAWINGS

Fig. 1 is a schematic perspective view of an SiC ingot in a first embodiment of the present invention.
Fig. 2 is a schematic sectional view of a crucible in the first embodiment of the present invention.
Fig. 3 is a sectional view taken along line III-III of Fig. 2.
Fig. 4 is a schematic sectional view of another crucible in the first embodiment of the present invention.
Fig. 5 is a schematic sectional view of another crucible in the first embodiment of the present invention.
Fig. 6 is a schematic sectional view of another crucible in the first embodiment of the present invention.
Fig. 7 is a schematic sectional view of the step for manufacturing an SiC ingot in the first embodiment of the present invention.
Fig. 8 is a sectional view taken along line VIII-VIII of Fig. 7.
Fig. 9 is a schematic perspective view of an SiC ingot in a second embodiment of the present invention.
Fig. 10 is a schematic perspective view of an SiC ingot in a third embodiment of the present invention.
Fig. 11 is a schematic perspective view of an SiC ingot in a fourth embodiment of the present invention.
Fig. 12 is a schematic perspective view of an SiC ingot in a fifth embodiment of the present invention.
Fig. 13 is a diagram to describe the {03-38} plane.
Fig. 14 is a schematic plan view of a configuration of a semiconductor substrate in a sixth embodiment of the present invention.
Fig. 15 is a schematic sectional view taken along line XV-XV of Fig. 14.
Fig. 16 is a schematic flowchart of a method for manufacturing a semiconductor substrate in the sixth embodiment of the present invention.
Fig. 17 is a schematic flow diagram of the step of forming a connecting portion of Fig. 16.
Fig. 18 is a schematic sectional view of the first step in a method for manufacturing a semiconductor substrate in the sixth embodiment of the present invention.
Fig. 19 is a schematic sectional view of the second step in a method for manufacturing a semiconductor substrate in the sixth embodiment of the present invention.
Fig. 20 is a schematic sectional view of the third step in a method for manufacturing a semiconductor substrate in the sixth embodiment of the present invention.
Fig. 21 is a schematic sectional view of a first modification of the first step in a method for manufacturing a semiconductor substrate in the sixth embodiment of the present invention.
Fig. 22 is a schematic sectional view of a second modification of the first step in a method for manufacturing a semiconductor substrate in the sixth embodiment of the present invention.
Fig. 23 is a schematic sectional view of a third modification of the first step in a method for manufacturing a semiconductor substrate in the sixth embodiment of the present invention.

### DESCRIPTION OF EMBODIMENTS

Embodiments of the present invention will be described based on the drawings. In the drawings, the same or corresponding elements having the same reference characters allotted, and description thereof will not be repeated. In the present specification, < >, ( ), and { } indicate the group orientation, individual plane, and group plane, respectively. In addition, although a negative index is to be indicated crystallographically with a "-" (bar) placed above a numeral, a minus sign will be placed before a numeral for the same in the present specification.

### (First Embodiment)

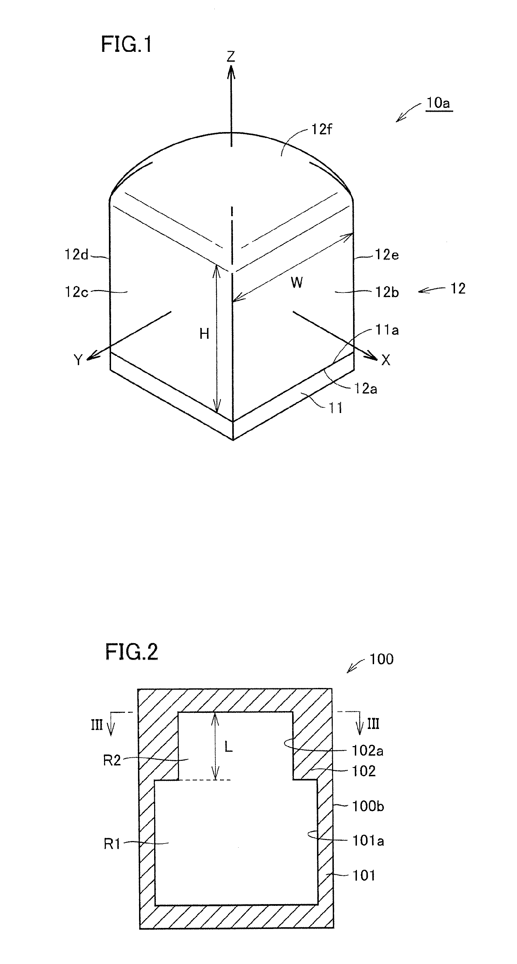

Fig. 1 is a schematic perspective view of an SiC ingot in a first embodiment of the present invention. First, an SiC ingot 10a according to an embodiment of the present invention will be described with reference to Fig. 1.

As shown in Fig. 1, SiC ingot 10a includes a seed substrate 11, and crystal 12 formed on seed substrate 11. Crystal 12 includes a bottom face 12a, four side faces 12b, 12c, 12d and 12e, and a growth face 12f.

Bottom face 12a is in contact with seed substrate 11. Bottom face 12a has four sides. Namely, bottom face 12a is substantially a quadrilateral. In the present embodiment, bottom face 12a takes a rectangular shape, preferably a square shape. The vertex where each of the four sides of bottom face 12a intersects may be rounded. Namely, bottom face 12a may be a chamfered quadrilateral.

The four side faces 12b, 12c, 12d and 12e extend from bottom face 12a in a direction intersecting the extending direction of bottom face 12a. In the present embodiment, four side faces 12b, 12c, 12d and 12e extend substantially perpendicular, preferably perpendicular, from bottom face 12a. Each of four side faces 12b, 12c, 12d and 12e preferably takes a quadrilateral shape, more preferably takes a rectangular shape.

Growth face 12f is connected with four side faces 12b, 12c, 12d and 12e, and located at the side opposite to bottom face 12a. Growth face 12f extends in a direction intersecting the extending direction of four side faces 12b, 12c, 12d and 12e. Growth face 12f corresponds to the outermost surface when crystal 12 is grown on seed substrate 11. Growth face 12f in the present embodiment is protuberant upwards in a direction opposite to bottom face 12a. In other words, growth face 12f is not horizontal, but rounded.

Bottom face 12a, side faces 12b, 12c, 12d and 12e and growth face 12f of the present embodiment are not processed. In this case, four side faces 12b, 12c, 12d and 12e are not dull, but mirrored. Moreover, four side faces 12b, 12c, 12d and 12e and growth face 12f do not have any scratches from polishing, shearing, and the like left.

At least one of bottom face 12a, side faces 12b, 12c, 12d and 12e and growth face 12f is preferably the {0001} plane (c plane), the {1-100} plane (m plane), the {11-20} plane (a plane), or a plane having an inclination within 10° relative to these planes. For example, the x direction, y direction and z direction in Fig. 1 correspond to the <11-20> direction (a axis direction), the <1-100> direction (m axis direction), and the <0001> direction (c axis direction), respectively. In this case, bottom face 12a is the {0001} plane. Side faces 12b and 12d are the {11-20} plane. Side faces 12c and 12e are the {1-100} plane. Growth face 12f is a plane having an inclination within 10° from the {0001} plane.

The {0001} plane, {1-100} plane and {11-20} plane are typical planes in an SiC substrate. By setting at least any of bottom face 12a, side faces 12b, 12c, 12d and 12e and growth face 12f to have a variation less than or equal to 10° of the off orientation from these faces in consideration of processing variation in the manufacturing step of an SiC substrate manufactured from an SiC ingot, formation of an epitaxial growth layer on an SiC substrate manufactured from SiC ingot 10a can be facilitated.

Seed substrate 11 is formed below bottom face 12a of crystal 12. Seed substrate 11 has a main surface 11a. Main surface 11a is in contact with bottom face 12a of crystal 12.

Main surface 11a preferably corresponds to the {0001} plane, or has an inclination within 10° relative to this plane. Since a stacked defect is not readily generated at crystal 12 formed on main surface 11a, the crystallinity of crystal 12 can be improved.

Bottom face 12a, four side faces 12b, 12c, 12d and 12e and growth face 12f in the present embodiment have substantially a parallel or substantially a perpendicular relationship with each other. Although SiC ingot 10a in the present embodiment is a rectangular solid except for the protuberant of growth face 12f (curved surface), the SiC ingot of the present invention is not limited to this shape. Each corner (the region of each of the sides) of the SiC ingot of the present invention may be rounded.

The size of SiC ingot 10a will be exemplified with reference to Fig. 1. The width W of four side faces12b, 12c, 12d and 12e is greater than or equal to 15 mm, preferably greater than or equal to 60 mm, and more preferably greater than or equal to 100 mm. The height H of four side face 12b is, for example, greater than or equal to 15 mm, preferably greater than or equal to 30 mm, more preferably greater than or equal to 50 mm.

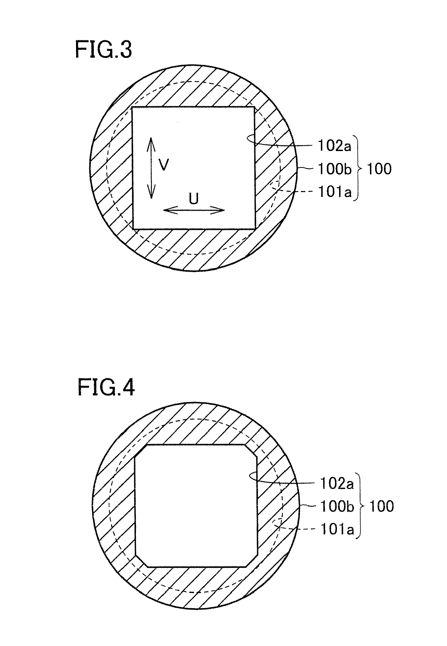

A crucible 100 in the present embodiment will be described with reference to Figs. 2-6. Crucible 100 of the present embodiment is a crucible directed to manufacturing the SiC ingot shown in Fig. 1. Fig. 2 is a schematic sectional view of a crucible in the present embodiment. Fig. 3 is a sectional view taken along line III-III of Fig. 2. Figs. 4-6 are schematic sectional views of another crucible in the present embodiment. Figs. 4-6 correspond to a cross section taken along line III-III in Fig. 2. As shown in Figs. 2 and 3, crucible 100 includes a first portion 101 and a second portion 102. First portion 101 forms a first region R1 in which a raw material is disposed. First portion 101 is located relatively at the upper area. Second portion 102 is connected to first portion 101. Second portion 102 forms a second region R2 in which a seed substrate is disposed so as to face the raw material. Second portion 102 is located relatively at the lower portion. First portion 101 and second portion 102 are formed integrally. First portion 101 includes a body for disposing a seed crystal, and a lid portion, and may be formed to allow separation between the main body and the lid.

As shown in Fig. 3, the cross sectional shape (horizontal cross section) of second portion 102 is a quadrilateral (in the present embodiment, a rectangle, preferably a square). In other words, the cross sectional shape (horizontal cross section) of inner circumferential face 102a of second portion 102 is a quadrilateral (in the present embodiment, a rectangle, preferably a square).

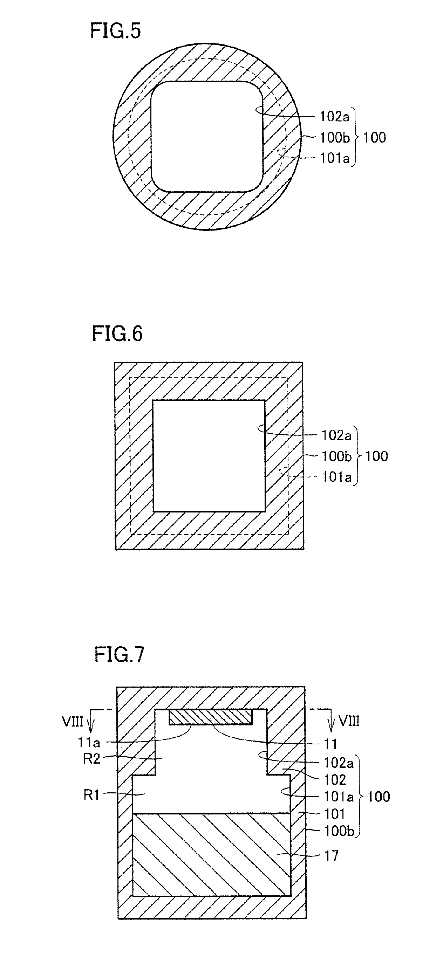

As shown in Figs. 4 and 5, the cross sectional shape (horizontal cross section) of second portion 102 may be a chamfered quadrilateral (in the present embodiment, a rectangle, preferably a square). The chamfering may be a 45° chamfer (C) with the angle of 2 intersecting sides being 45°, as shown in Fig. 4, or a rounded chamfer (R) with the angle of two intersecting sides rounded, as shown in Fig. 5. In the case where second portion 102 has a chamfered quadrilateral cross section, concentration of the stress at the corners of growing crystal 12 can be suppressed.

The cross sectional shape (horizontal cross section) of first portion 101 may be a circle, as shown in Figs. 3-5, a quadrilateral as shown in Fig. 6, or another shape.

Inner circumferential face 101a of first portion 101 preferably includes a region entirely projected on inner circumferential face 102a of second portion 102, when viewed from above (from the side of second portion 102). Although the cross section of first region R1 enclosed by inner circumferential face 101a of first portion 101 is larger than the cross section of second region R2 enclosed by inner circumferential face 102a of second portion 102 in Figs. 2-6, they may be the same instead. In other words, inner circumferential face 101a of first portion 101 and inner circumferential face 102a of second portion 102 may be located on the same curved surface or on the same plane.

The height of second portion 102 (height L in Fig. 2) is preferably approximately equal to the height of silicon carbide ingot 10a to be grown (height H in Fig. 1).

Although the outer circumferential face of first portion 101 and the outer circumferential face of second portion 102 (outer circumferential face 100b of crucible 100) are located on the same curved face or same plane in Figs. 2-6, the outer circumferential faces may be of different shape instead.

The material of first and second portions 101 and 102 preferably includes carbon (C), more preferably made of C, although not particularly limited thereto. Such a material includes, for example, graphite. In other words, crucible 100 is preferably made of graphite. Since carbon is a constituent element of the SiC ingot, any carbon, if introduced into the SiC ingot due to sublimation of a portion of the crucible, will not act as impurities. Therefore, the crystallinity of manufactured SiC ingot 100a can be rendered favorable. Particularly, generation of a crack in the crucible can be suppressed since graphite is stable at high temperature.

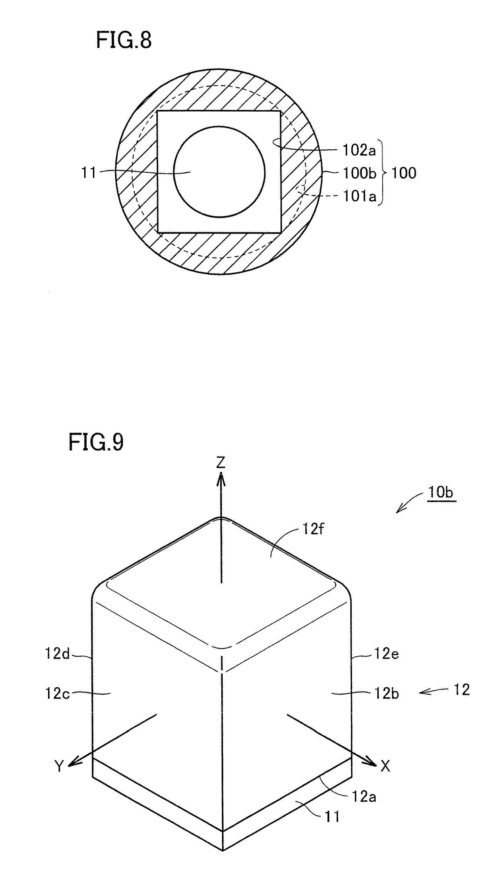

Next, a method for manufacturing SiC ingot 10a in the present embodiment will be described hereinafter with reference to Figs. 1, 7 and 8. In the method for manufacturing SiC ingot 10a in the present embodiment, SiC ingot 10a is produced using crucible 100 shown in Figs. 2 and 3. Fig. 7 is a schematic sectional view of the step of manufacturing an SiC ingot of the present embodiment. Fig. 8 is a sectional view taken along line VIII-VIII of Fig. 7.

As shown in Figs. 7 and 8, raw material 17 is disposed in first portion 101 (first region R1) of crucible 100. In the present embodiment, raw material 17 is disposed in first region R1 at a lower portion of crucible 100. Raw material 17 may be powder or a sintered compact. For example, polycrystalline SiC powder or SiC sintered compact is prepared.

Then, a seed substrate 11 is disposed in second portion 102 (second region R2) of crucible 100. In the present embodiment, seed substrate 11 is disposed in second region R2 located at the upper portion of crucible 100, so as to face raw material 17.

Seed substrate 11 has a main surface 11a preferably corresponding to the {0001} plane, the {1-100} plane, the {11-20} plane, or a plane having an inclination within 10° relative to these planes. In this case, at a growing step that will be described afterwards, there can be grown crystal 12 having a growth face 12f corresponding to the {0001} plane, the {1-100} plane, the {11-20} plane, or a plane having an inclination within 10° relative to these planes.

Main surface 11a of seed substrate 11 may take the shape of a circle or a quadrilateral. The composition of seed substrate 11 is not particularly limited, and may be identical or different from the composition of crystal 12 to be grown. From the standpoint of improving the crystallinity of growing crystal 12, it is preferable to prepare crystal 12 of the same composition as seed substrate 11.

Seed substrate 11 is arranged in second portion 102 such that at least one side (for example, the direction of arrow U or V in Fig. 3) of the four sides constituting a quadrilateral or chamfered quadrilateral for the cross sectional shape of second portion 102 in crucible 100 corresponds to the <0001> direction, the <1-100> direction, the <11-20> direction, or a direction having an inclination within 10° relative to these directions of SiC ingot 10a to be grown in the growing step. In this case, the side of the face having substantially a quadrilateral shape where seed substrate 11 of second portion 102 of crucible 100 is arranged also plays the role as an orientation flat, notch, or the like. The reason why the direction of at least one side of the quadrilateral or chamfered quadrilateral is defined as set forth above is to grow crystal 12 such that at least one of bottom face 12a, side faces 12b, 12c, 12d and 12e and growth face 12f corresponds to the {0001} plane, the {1-100} plane, the {11-20} plane, or a plane having an inclination within 10° relative to these planes.

Next, crystal 12 is grown by sublimation of raw material 17 through heating to deposit hydrogen gas on seed substrate 11.

Specifically, raw material 17 is heated by a heater portion up to a temperature at which raw material 17 sublimes. By this heating, raw material 17 is sublimed to generate sublimation gas. This sublimation gas is resolidified at the surface of seed substrate 11 set at a temperature lower than that of raw material 17. As an example of the growth temperature, the temperature of raw material 17 is maintained at 2300°C to 2400°C, and the temperature of seed substrate 11 is maintained at 2100°C to 2200°C. Accordingly, crystal 12 is grown on seed substrate 11. The growth temperature may be maintained at a predetermined temperature during growth, or changed at a certain rate during growth.

Since second portion 102 of crucible 100 has a cross sectional shape of a quadrilateral in the growing step, crystal 12 having a quadrilateral cross section can be grown on seed substrate 11.

In the growing step, crystal 12 is grown in the <0001> direction, the <1-100> direction, the <11-20> direction, or in a direction having an inclination within 10° relative to these directions. Accordingly, growth face 12f (or bottom face 12a) of crystal 12 will correspond to the {0001} plane, the {1-100} plane, the {11-20} plane, or a plane having an inclination within 10° relative to these planes.

Then, the interior of crucible 100 is cooled down to room temperature. SiC ingot 10a having seed substrate 11 produced from crucible 100 and crystal 12 formed on seed substrate 11, is taken out. Accordingly, SiC ingot 10a shown in Fig. 1 can be manufactured.

SiC ingot 10a in the present embodiment is not subjected to a process to arrange the shape after growth of crystal 12. Therefore, four side faces 12b, 12c, 12d and 12e of SiC ingot 10a in the present embodiment are mirrored, and not dull. Moreover, four side faces 12b, 12c, 12d and 12e and growth face 12f do not have any scratches from polishing, shearing, and the like left.

In a method for manufacturing SiC ingot 10a in the present embodiment, manufacturing is performed using crucible 100 shown in Fig. 3. The present invention is not limited thereto. Crucible 100 shown in Figs. 4-6, for example, may be used.

The effect of SiC ingot 10a, manufacturing method thereof, and crucible 100 of the present embodiment will be described hereinafter.

The inventors drew their attention to the fact that an SiC substrate having a plane shape of substantially a quadrilateral is advantageous in the following issues. An SiC substrate having a circular plane shape must have an orientation flat and/or notch formed to indicate the plane direction. However, an SiC substrate having a plane shape of a quadrilateral can indicate the plane orientation by the cutting manner of the end face (side face) even without having to form an orientation flat or notch.

Further, in the case where a plurality of SiC substrates have a plane shape of a quadrilateral, the plurality of SiC substrates can be aligned in plane with the space therebetween reduced. Therefore, in the case where a wafer is produced with a plurality of SiC substrates aligned in plane to be combined with the underlying substrate, a substrate having a plane shape of a quadrilateral can be used suitably.

The inventors studied diligently about means for reducing the cost in manufacturing an SiC substrate having a plane shape of a quadrilateral from an SiC ingot. As a result, they arrived at the present invention of manufacturing an SiC ingot 10a that is substantially a rectangular solid during the crystal growth.

By an SiC ingot 10a having the shape of substantially a rectangular solid, an SiC substrate having a plane shape of a quadrilateral can be manufactured by slicing in a direction parallel to bottom face 12a.

Further, since the plane orientation of each of four side faces 12b, 12c, 12d and 12e differ from the plane orientation of bottom face 12a, an SiC substrate having the desired plane orientation for the main surface can be readily formed.

By realizing an SiC ingot 10a of substantially a rectangular solid shape, a quadrilateral SiC substrate can be readily manufactured. As a result of diligent study to realize such an SiC ingot 10a, a crucible 100 in which a second portion 102 for disposing seed substrate 11 has a quadrilateral or chamfered quadrilateral cross section was completed.

A possible approach is to slice out an SiC ingot having the maximum inscribed rectangular solid from a conventionally manufactured SiC ingot that is substantially in a cylindrical shape. However if an SiC ingot of substantially a rectangular solid shape is produced in this case, approximately 1/3 the material of the SiC ingot having substantially a cylindrical shape will be wasted. In the case where SiC ingot 10a of substantially a rectangular solid shape is manufactured by crystal growth as in the present embodiment, approximately at least 95% of SiC ingot 10a can be used effectively, although the region for correcting surface roughness, displacement and the like of SiC ingot 10a will be wasted. Thus, the wasted material in SiC ingot 10a can be reduced.

Further, SiC ingot 10a of the present embodiment can eliminate the processing procedure to form an orientation flat, notch, or the like, the processing procedure to modify the shape, the procedure to subject the circular substrate to dicing and the like. Accordingly, the time required for processing can be shortened.

According to SiC ingot 10a, manufacturing method thereof, and crucible 100 of the present embodiment, wasted material can be reduced and the processing procedure alleviated. Therefore, there can be realized an SiC ingot allowing reduction in cost in manufacturing an SiC substrate.

### (Second Embodiment)

Fig. 9 is a schematic perspective view of an SiC ingot 10b in a second embodiment of the present invention. As shown in Fig. 9, SiC ingot 10b in the present embodiment has a configuration basically similar to that of SiC ingot 10a of the first embodiment shown in Fig. 1, and differs in that a growth face 12f is processed. Growth face 12f in the present embodiment is a flat face. Growth face 12f preferably corresponds to the {0001} plane, the {1-100} plane, the {11-20} plane, or a plane having an inclination within 10° relative to these planes.

Four side faces 12b, 12c, 12d and 12e are mirrored, and not dull. Further, four side faces 12b, 12c, 12d and 12e do not have any scratches from polishing, shearing, and the like left.

A method for manufacturing SiC ingot 10b in the present embodiment has a configuration basically similar to that of the method for manufacturing an SiC ingot 10 in the first embodiment, and differs in further including the step of processing growth face 12f. The processing method is not particularly limited, and planarization is effected by polishing, or the like.

### (Third Embodiment)

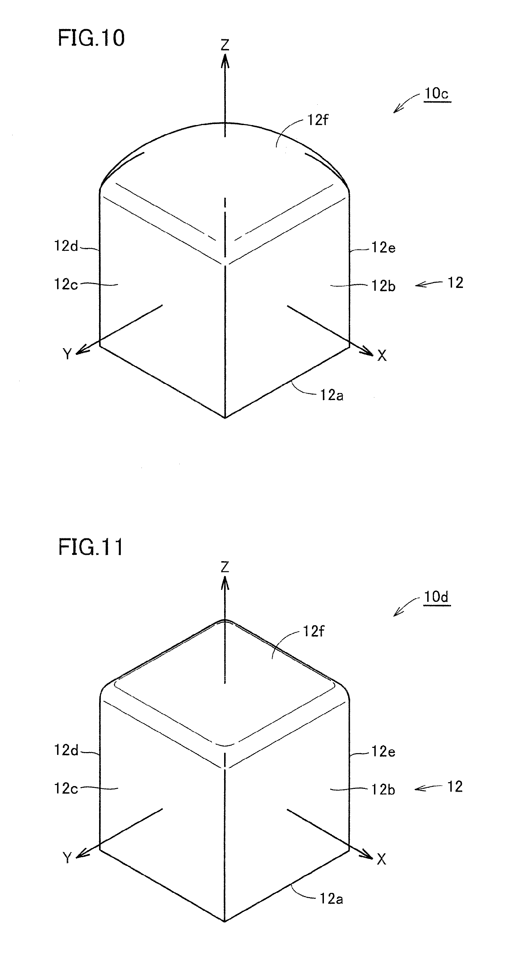

Fig. 10 is a schematic perspective view of an SiC ingot 10c in a third embodiment of the present invention. As shown in Fig. 10, SiC ingot 10c in the present embodiment has a configuration basically similar to that of Si C ingot 10a in the first embodiment shown in Fig. 1, and differs in that seed substrate 11 is absent.

A method for manufacturing SiC ingot 10c in the present embodiment has a configuration basically similar to that of the method for manufacturing an SiC ingot 10a in the first embodiment, and differs in further including the step of removing seed substrate 11. The removing step may be carried out by removing only seed substrate 11, or removing seed substrate 11 and a portion of grown crystal 12.

The removing method is not particularly limited, and may include mechanical removing methods such as cutting, grinding, cleavage, and the like. Cutting includes removing at least seed substrate 11 from SiC ingot 10a mechanically through a slicer or the like having a peripheral cutting edge of a diamond electrodeposition wheel. Grinding includes bringing the surface in contact while the grindstone is rotated to grind away in the thickness direction. Cleavage includes dividing the crystal along the crystallite lattice plane. A chemical removing method such as etching may be employed.

### (Fourth Embodiment)

Fig. 11 is a schematic perspective view of an SiC ingot 10d according to a fourth embodiment of the present invention. As shown in Fig. 11, SiC ingot 10d in the present embodiment has a configuration basically similar to that of SiC ingot 10b in the second embodiment of Fig. 9, and differs in that seed substrate 11 is absent.

The method for manufacturing SiC ingot 10d in the present embodiment has a configuration basically similar to that of the method for manufacturing SiC ingot 10b in the second embodiment, and differs in further including the step of removing seed substrate 11. The removing step is likewise with the third embodiment, and the description thereof will not be repeated.

It is to be noted that SiC ingot 10a of the first embodiment is not subjected to a machining process at all, after the growing step. SiC ingot 10b of the second embodiment has only growth face 12f machined, after the growing step. SiC ingot 10c of the third embodiment does not have crystal 12 per se subjected to machining at all, or only bottom face 12a is subjected to machining, after the growing step. SiC ingot 10d of the fourth embodiment has only growth face 12f subjected to machining, or only growth face 12f and bottom face 12a subjected to machining, after the growing step. However, the SiC ingot of the present invention is not limited to the configuration of the first to fourth embodiments. The SiC ingot of the present invention must have at least one of bottom face 12a, side faces 12b, 12c, 12d and 12e, and growth face 12f subjected to a machining process.

### (Fifth Embodiment)

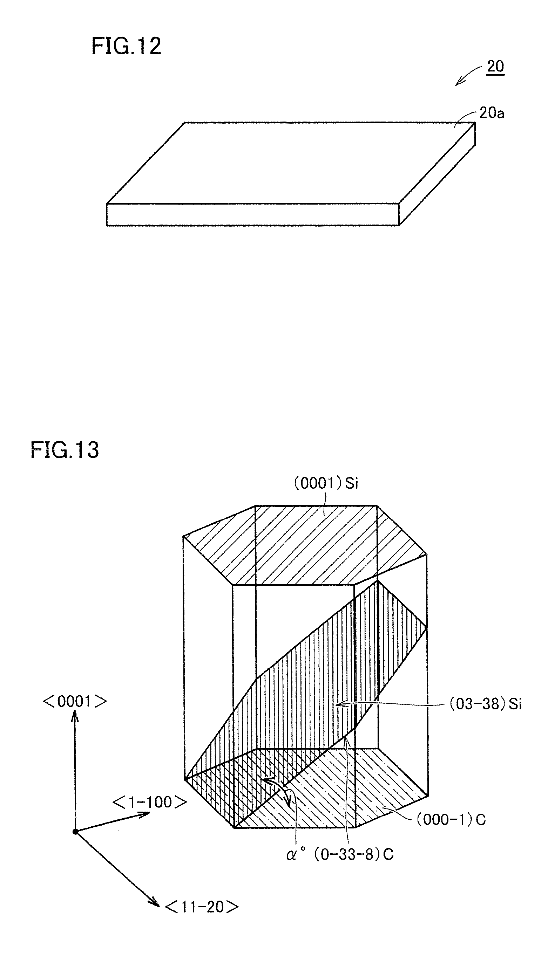

Fig. 12 is a schematic perspective view of an SiC substrate in a fifth embodiment of the present invention. An SiC substrate of the present embodiment will be described with reference to Fig. 12.

SiC substrate 20 of the present invention is produced from any of SiC ingots 10a-10d of the first to fourth embodiments. SiC substrate 20 has a main surface 20a. Main surface 20a is preferably a quadrilateral, more preferably a rectangle.

Main surface 20a preferably has an off angle greater that or equal to 50° and less than or equal to 65° relative to the {0001} plane. By producing a metal oxide semiconductor field effect transistor (MOSFET) using such an SiC substrate 20, there can be obtained an MOSFET having formation of interface states at the channel region reduced and the ON resistance lowered.

The angle between the off orientation of main surface 20a and the <1-100> direction or <11-20> direction of SiC substrate 20 is preferably less than or equal to 5°. The <1-100> direction and <11-20> direction are typical off orientations in SiC substrate 20. By setting the variation in the off orientation caused by variation in slicing or the like in the manufacturing step of SiC substrate 20 to less than or equal to 5°, formation of an epitaxial growth layer on SiC substrate 20 can be facilitated.

The off angle of main surface 20a relative to the {03-38} plane in the <1-100> direction of SiC substrate 20 is further preferably greater than or equal to - 3° and less than or equal to 5°. Accordingly, the channel mobility when an MOSFET is produced using SiC substrate 20 can be further improved.

The "off angle of main surface 20a relative to the {03-38} plane in the <1-100> direction" refers to the angle between the orthogonal projection of the normal line of main surface 20a on the projection plane defined by the <1-100> direction and <0001> direction, and the normal line of the {03-38} plane. The sign thereof is positive in the case where the aforementioned orthogonal projection approaches the <1-100> direction in parallel, and is negative in the case where the aforementioned orthogonal projection approaches the <0001> direction in parallel.

Referring to Fig. 13, the {03-38} plane is a plane between the {0001} plane and {1-100} plane, and α is approximately 55° (54.7°). In other words, the {03-38} plane refers to a plane having an inclination of approximately 35° (35.3°) relative to the <0001> axis direction. Therefore, likewise with the {0001} plane, the {03-38} plane has the polarities of a plane where Si is exposed (Si plane), and a plane where C is exposed (C plane). Fig. 13 is a diagram to describe the {03-38} plane.

The plane orientation of main surface 20a is not particularly limited to the aforementioned plane orientation, and may correspond to the {0001} plane or the like, in consideration of easiness in manufacturing.

The method for manufacturing an SiC substrate in the present embodiment is basically similar to the method for manufacturing SiC ingots 10a-20d in the first to fourth embodiments, and differs in further including the step of slicing SiC substrate 20 from SiC ingots 10a-20d.

Although the slicing method is not particularly limited, a mechanical removing method such as cutting may be employed. Cutting refers to slicing SiC substrate 20 from SiC ingots 10a-10b mechanically using a slicer having a peripheral cutting edge, a slicer having an inner cutting edge, a wire saw or the like. For the sake of easiness in slicing, it is particularly preferable to slice SiC substrate 20 from SiC ingot 10a-20d using a wire saw.

The slicing step is carried out such that main surface 20a has the desired plane orientation. Therefore, the substrate may be sliced parallel to or not parallel to bottom face 12a of SiC ingot 10a-10d.

In the slicing step, SiC substrate 20 may be sliced after surface machining all the faces of SiC ingot 10a-10d.

After SiC substrate 20 is sliced out, main surface 20a and the face at a side opposite to main surface 20a may be subjected to polishing, surface treatment, or the like. The polishing method and surface treatment method are not particularly limited, and an arbitrary method can be employed.

### (Sixth Embodiment)

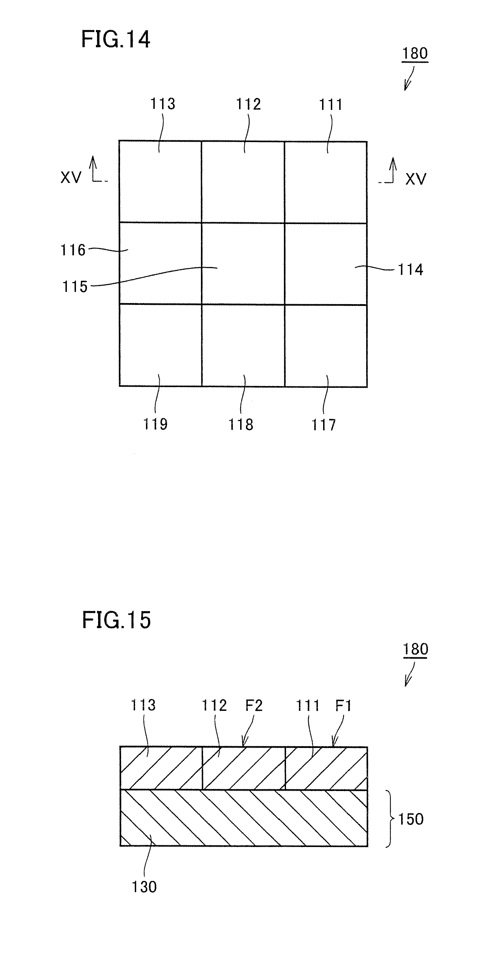

Referring to Fig. 14 and Fig. 15, a semiconductor substrate 180 of the present embodiment includes a plurality of SiC substrates 111-119 (silicon carbide substrates) each having a single-crystal structure, and a connecting portion 150. SiC substrates 111-119 corresponds to SiC substrate 20 of the fifth embodiment. Connecting portion 150 includes a growth layer 130 made of SiC, and is substantially constituted of growth layer 130 in the present embodiment. Growth layer 130 connects the back-side surfaces of SiC substrates 111-119 (surfaces opposite to the surfaces shown in Fig. 14) to one another, whereby SiC substrates 111-119 are fixed to one another. SiC substrates 111-119 respectively have exposed front-side surfaces on the same plane. For example, SiC substrates 111 and 112 have front-side surfaces F1 and F2, respectively (Fig. 15). Thus, semiconductor substrate 180 has a surface larger than the surface of each of SiC substrates 111-119. Hence, in the case of using semiconductor substrate 180, semiconductor devices employing SiC can be manufactured more effectively than in the case of using each of SiC substrates 111-119 solely.

Next, a method for manufacturing semiconductor substrate 180 of the present embodiment will be described. For the sake of simplification, only SiC substrates 111 and 112 of SiC substrates 111-119 may be explained, but the same applies to SiC substrates 113-119.

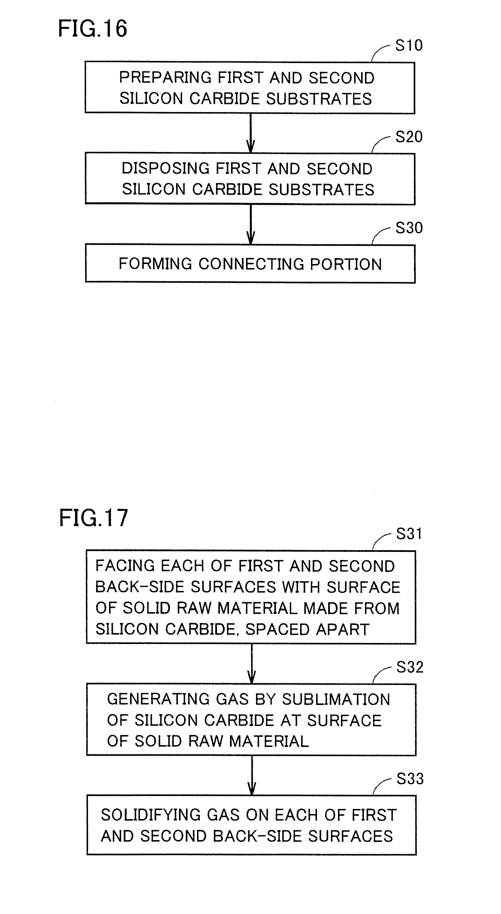

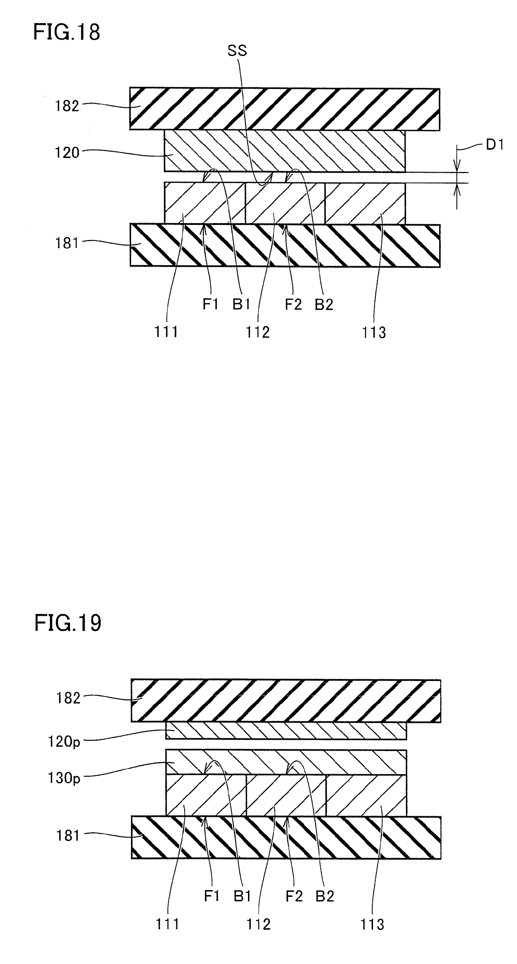

Referring to Fig. 18, SiC substrate 111 (first silicon carbide substrate) and SiC substrate 112 (second silicon carbide substrate) each having a single-crystal structure are prepared (Fig. 16: step S10). SiC substrate 111 has a front-side surface F1 (first front-side surface) and a back-side surface B1 (first back-side surface) opposite to each other. SiC substrate 112 has a front-side surface F2 (second front-side surface) and a back-side surface B2 (second back-side surface) opposite to each other. Specifically, for example, SiC substrates 111 and 112 are prepared by the manufacturing method of SiC substrate 20 of the fifth embodiment. Preferably, each of back-side surfaces B1 and B2 has a roughness Ra of not more than 100 µm. Each of back-side surfaces B1 and B2 may be a surface formed by the above-described slicing (so-called "as-sliced surface") in the fifth embodiment, i.e., a surface not polished after the slicing. Preferably, each of front-side surfaces F1 and F2 have been subjected to polishing after the slicing step (slice) in the fifth embodiment.

Next, SiC substrates 111 and 112 are placed on a first heating body 81 in a treatment chamber with each of back-side surfaces B1 and B2 being exposed in one direction (upward in Fig. 18) (Fig. 16: step S20). Namely, when in a plan view, SiC substrates 111 and 112 are arranged side by side.

Preferably, this arrangement is accomplished by disposing back-side surfaces B1 and B2 on the same flat plane or by disposing front-side surfaces F1 and F2 on the same flat plane.

Further, the minimum space between SiC substrates 111 and 112 (minimum space in a lateral direction in Fig. 18) is preferably 5 mm or smaller, more preferably, 1 mm or smaller, and further preferably 100 µm or smaller, and particularly preferably 10 µm or smaller. Specifically, for example, the substrates, which have the same rectangular shape, may be arranged in the form of a matrix with a space of 1 mm or smaller therebetween.

Next, connecting portion 150 (Fig. 15) is formed to connect back-side surfaces B1 and B2 to each other (Fig. 16: step S30). This step of forming connecting portion 50 includes a step of forming growth layer 130 (Fig. 15). For the step of forming growth layer 130, a sublimation method, preferably, a close-spaced sublimation method is used. The following describes the step of forming connecting portion 150 in detail.

First, each of back-side surfaces B1 and B2 exposed in the one direction (upward in Fig. 18) and a surface SS of a solid raw material 120 disposed in the one direction (upper side in Fig. 18) relative to back-side surfaces B1 and B2 are arranged to face each other with a space D1 provided therebetween (Fig. 17: step S31). Preferably, space D1 has an average value smaller than the mean free path for a sublimation gas in the sublimation method, and is for example, 1 µm or greater and 1 cm or smaller. This sublimation gas is a gas formed by sublimation of solid SiC, and includes Si, Si₂C, and SiC₂, for example.

Solid raw material 120 is made of SiC, and is preferably a piece of solid matter of silicon carbide, specifically, an SiC wafer, for example. Solid raw material 120 is not particularly limited in crystal structure of SiC. Further, surface SS of solid raw material 120 preferably has a roughness Ra of 1 mm or smaller.

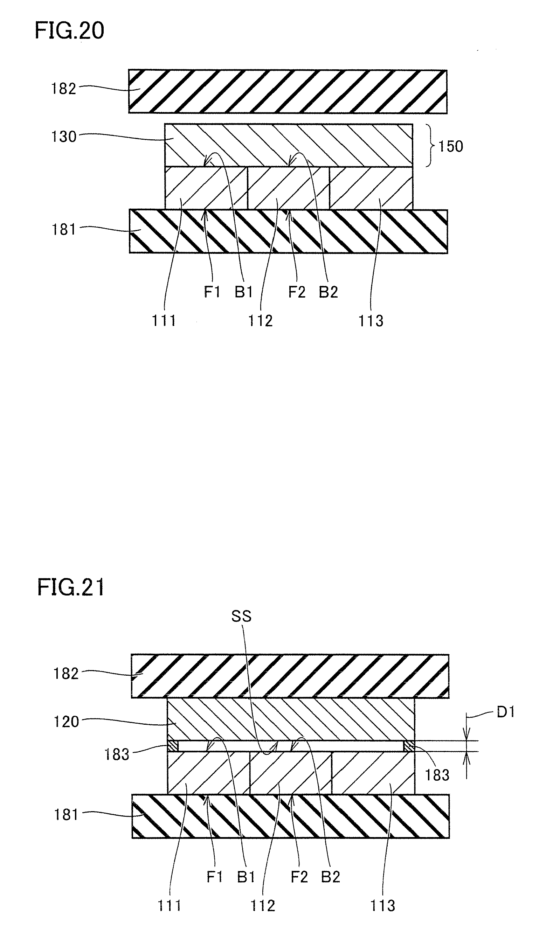

In order to provide space D1 (Fig. 18) more reliably, there may be used a spacer 83 (Fig. 21) having a height corresponding to space D1. This method is particularly effective when the average value of space D1 is approximately 100 µm or more.

Next, SiC substrates 111 and 112 are heated by first heating body 181 to a predetermined substrate temperature. Solid raw material 120 is heated by second heating body 182 to a predetermined raw material temperature. When solid raw material 120 is thus heated to the raw material temperature, SiC is sublimated at surface SS of the solid raw material to generate a sublimate, i.e., gas (Fig. 17: step S32). The gas thus generated is supplied onto each of back-side surfaces B1 and B2 from one direction (from above in Fig. 18).

Preferably, the substrate temperature is set lower than the raw material temperature, and is more preferably set so that the difference between the temperatures is 1°C or greater and 100°C or smaller. Further, the substrate temperature is preferably 1800°C or greater and 2500°C or smaller.

Referring to Fig. 19, the gas supplied as described above is solidified and accordingly recrystallized on each of back-side surfaces B1 and B2 (Fig. 17: step S33). In this way, a growth layer 130p is formed to connect back-side surfaces B1 and B2 to each other. Further, solid raw material 120 (Fig. 18) is consumed and reduced in size to be a solid raw material 120p.

Referring mainly to Fig. 20, as the sublimation proceeds, solid raw material 120p (Fig. 19) is run out. Accordingly, growth layer 130 is formed to serve as connecting portion 150 for connecting back-side surfaces B1 and B2 to each other. Then, the step of polishing each of front-side surfaces F1 and F2 may be performed.
In this case, an epitaxial growth layer of high quality may be formed on front-side surfaces F1 and F2.

In the formation of growth layer 130, the atmosphere in the treatment chamber may be obtained by reducing the pressure of the atmosphere. In this case, the pressure of the atmosphere is preferably higher than 10⁻¹ Pa and lower than 10⁴ Pa.

The atmosphere may be an inert gas. An exemplary inert gas usable is a noble gas such as He or Ar; a nitrogen gas; or a mixed gas of the noble gas and nitrogen gas. When using the mixed gas, a ratio of the nitrogen gas is, for example, 60%. Further, the pressure in the treatment chamber is preferably 50 kPa or smaller, and is more preferably 10 kPa or smaller.

Further, growth layer 130, including growth layer 130p, preferably has a single-crystal structure. More preferably, growth layer 130 on back-side surface B1 has a crystal plane inclined by 10° or smaller relative to the crystal plane of back-side surface B1, and growth layer 130 on back-side surface B2 has a crystal plane inclined by 10° relative to the crystal plane of back-side surface B2. These angular relations can be readily realized by expitaxially growing growth layer 130 on back-side surfaces B1 and B2.

The crystal structure of each of SiC substrates 111, 112 is preferably of hexagonal system, and is more preferably 4H-SiC or 6H-SiC. Moreover, it is preferable that SiC substrates 111, 112 and growth layer 130 be made of SiC single crystal having the same crystal structure.

When the SiC substrate (SiC substrates 111, 112, and the like) and growth layer 130 are made of the SiC single crystal having the same crystal structure, there may be a difference in crystallographic property therebetween. Examples of such a property include defect density, crystal quality, and impurity concentration. This will be described hereinafter

Growth layer 130 may have a defect density larger than those of SiC substrates 111-119. Hence, connecting portion 150 substantially constituted of Growth layer 130 can be formed readily irrespective of its size being larger than the size of each of SiC substrates 111-119. Specifically, growth layer 130 may have a micropipe density larger than those of SiC substrates 111-119. Further, growth layer 130 may have a threading screw dislocation density larger than those of SiC substrates 111-119. Further, growth layer 130 may have a threading edge dislocation density larger than those of SiC substrates 111-119. Further, growth layer 130 may have a basal plane dislocation density larger than those of SiC substrates 111-119. Further, growth layer 130 may have a composite dislocation density larger than those of SiC substrates 111-119. Further, growth layer 130 may have a stacking defect density larger than those of SiC substrates 111-119. Further, growth layer 130 may have a point defect density larger than those of SiC substrates 111-119.

Further, the quality of the crystal of growth layer 130 may be lower than those of the crystal of SiC substrates 111-119. Hence, connecting portion 150 substantially constituted of growth layer 130 can be formed readily irrespective of its size being larger than the size of each of SiC substrates 111-119. Specifically, the full width at half maximum in the X-ray rocking curve of growth layer 130 may be larger than those of SiC substrates 111-119.

Further, the concentration in each of SiC substrates 111 and 112 is preferably different from the impurity concentration of growth layer 130. More preferably, growth layer 130 has an impurity concentration higher than that of each of SiC substrates 111 and 112. It should be noted that the impurity concentration in each of SiC substrates 111, 112 is, for example, 5 × 10¹⁶ cm⁻³ or greater and 5 × 10¹⁹ cm⁻³ or smaller. Further, growth layer 130 has an impurity concentration of, for example, 5 × 10 cm⁻³ or greater and 5 × 10²¹ cm⁻³ or smaller. As the impurity, nitrogen or phosphorus can be used, for example. It should be noted that the impurity included in growth layer 130 and the impurity included in each of SiC substrates 111 and 112 may be different from each other.

Further preferably, front-side surface F1 has an off angle of 50° or greater and 65° or smaller relative to the {0001} plane of SiC substrate 111 and front-side surface F2 has an off angle of 50° or greater and 65° or smaller relative to the {0001} plane of the SiC substrate.

More preferably, the angle between the off orientation of front-side surface F1 and the <1-100> direction of SiC substrate 111 is 5° or smaller, and the angle between the off orientation of front-side surface F2 and the <1-100> direction of SiC substrate 112 is 5° or smaller.

Further preferably, front-side surface F1 has an off angle of -3° or greater and 5° or smaller relative to the {03-38} plane in the <1-100> direction of SiC substrate 111, and front-side surface F2 has an off angle of -3° or greater and 5° or smaller relative to the {03-38} plane in the <1-100> direction of SiC substrate 112.

It should be noted that the "off angle of surface F1 relative to the {03-38} plane in the <1-100> direction" refers to an angle between an orthogonal projection of the normal line of front-side surface F2 to a projection plane defined by the <1-100> direction and the <0001> direction, and the normal line of the {03-38} plane. The sign thereof is positive value when the orthogonal projection approaches in parallel with the <1-100> direction, whereas the sign is negative when the orthogonal projection approaches in parallel with the <0001> direction. The same applies to the "off angle of front-side surface F2 relative to the {03-38} plane in the <1-100> direction".

Further, the angle between the off orientation of front-side surface F1 and the <11-20> direction of substrate 111 is 5° or smaller. The angle between the off orientation of front-side surface F2 and the <11-20> direction of substrate 112 is 5° or smaller.

According to the present embodiment, SiC substrates 111 and 112 are combined as one semiconductor substrate 180 with a connecting portion 150 therebetween, as shown in Fig. 15. Specifically, semiconductor substrate 180 of the present embodiment is obtained by having a plurality of SiC substrates 20 of the fifth embodiment aligned on the same plane, and combined. Semiconductor substrate 180 includes both front-side surfaces F1 and F2 of each of SiC substrates as the substrate plane where a semiconductor device such as a transistor is formed. In other words, semiconductor substrate 180 has a larger substrate plane, as compared to the case where any of SiC substrates 111 and 112 is used solely. Therefore, by semiconductor substrate 180, a semiconductor device employing SiC can be manufactured efficiently.

In addition, since growth layer 130 formed on back-side surfaces B1 and B2 is also made of SiC as with SiC substrates 111 and 112, physical properties of the SiC substrates and growth layer 130 are close to one another. Accordingly, warpage or cracks of semiconductor substrate 180 resulting from a difference in physical property therebetween can be suppressed.

Further, utilization of the sublimation method allows growth layer 130 to be formed speedily with high quality. When the sublimation method thus utilized is the close-spaced sublimation method, growth layer 130 can be formed more uniformly.

Further, when the average value of space D1 (Fig. 18) between each of back-side surfaces B1 and B2 and the surface of solid raw material 120 is 1 cm or smaller, the distribution in film thickness of growth layer 130 can be reduced. Furthermore, when the average value of space D1 is 1 mm or smaller, the distribution in film thickness of growth layer 130 can be reduced further. So far as the average value of space D1 is 1 µm or greater, sufficient space for sublimation of SiC can be ensured.

In the step of forming growth layer 130 (Fig. 20), the temperatures of SiC substrates 111 and 112 are set lower than that of solid raw material 120 (Fig. 18). This allows the sublimated SiC to be efficiently solidified on SiC substrates 111 and 112.

Further, the step of forming growth layer 130 (Fig. 18-Fig. 20) is performed to allow growth layer 130 to connect back-side surfaces B1 and B2 to each other. This allows SiC substrates 111 and 112 to be connected only by growth layer 130. In other words, SiC substrates 111 and 112 are connected by such a homogeneous material.

Further, the step of disposing SiC substrates 111 and 112 is preferably performed to allow the minimum space between SiC substrates 111 and 112 to be 1 mm or smaller. Accordingly, growth layer 130 can be formed to connect back-side surface B1 of SiC substrate 111 and back-side surface B2 of SiC substrate 112 to each other more reliably.

Further, growth layer 130 preferably has a single-crystal structure. Accordingly, growth layer 130 has physical properties close to the physical properties of SiC substrates 111 and 112 each having a single-crystal structure.

More preferably, growth layer 130 on back-side surface B1 has a crystal plane inclined by 10° or smaller relative to that of back-side surface B1. Further, growth layer 130 on back-side surface B2 has a crystal plane inclined by 10° or smaller relative to that of back-side surface B2. Accordingly, growth layer 130 has anisotropy close to that of each of SiC substrates 111 and 112.

Further, preferably, each of SiC substrates 111 and 112 has an impurity concentration different from that of growth layer 130. Accordingly, there can be obtained semiconductor substrate 180 (Fig. 15) having a structure of two layers with different impurity concentrations.

Furthermore, the impurity concentration in growth layer 130 is preferably higher than the impurity concentration in each of SiC substrates 111 and 112. This allows the resistivity of growth layer 130 to be smaller than those of SiC substrates 111 and 112. Accordingly, there can be obtained a semiconductor substrate 180 suitable for manufacturing of a semiconductor device in which a current flows in the thickness direction of growth layer 130, i.e., a vertical type semiconductor device.

Preferably, front-side surface F1 has an off angle greater than or equal to 50° and less than or equal to 65° relative to the {0001} plane of SiC substrate 111. and front-side surface F2 has an off angle greater than or equal to 50° and less than or equal to 65° relative to the {0001} plane of SiC substrate 112. Accordingly, channel mobility can be higher in each of front-side surfaces F1 and F2 than in the case where each of front-side surfaces F1 and F2 corresponds to the {0001} plane.

More preferably, the angle between the off orientation of front-side surface F1 and the <1-100> direction of SiC substrate 111 is 5° or smaller, and the angle between the off orientation of front-side surface F2 and the <1-100> direction of SiC substrate 112 is 5° or smaller. This allows for higher channel mobility in each of front-side surfaces F1 and F2.

Further, front-side surface F1 preferably has an off angle greater than or equal to -3° and less than or equal to 5° relative to the {03-38} plane in the <1-100> direction of SiC substrate 111, and front-side surface F2 preferably has an off angle greater than or equal to -3° and less than or equal to 5° relative to the {03-38} plane in the <1-100> direction of SiC substrate 112. This allows for further higher channel mobility in each of front-side surfaces F1 and F2.

Further preferably, the angle between the off orientation of front-side surface F1 and the <11-20> direction of SiC substrate 111 is 5° or smaller, and the angle between the off orientation of front-side surface F2 and the <11-20> direction of SiC substrate 112 is 5° or smaller. This allows for higher channel mobility in each of front-side surfaces F1 and F2 than in the case where each of the front-side surfaces F1 and F2 corresponds to the {0001} plane.

In the description above, the SiC wafer is exemplified as solid raw material 120, but solid raw material 120 is not limited to this and may be SiC powder or a SiC sintered compact, for example.

Further, as first and second heating bodies 181, 182, any heating bodies can be used as long as they are capable of heating a target object. For example, the heating bodies can be of the resistance heating type employing a graphite heater, or of the induction heating type.

In Fig. 18, the space is provided between each of back-side surfaces B1 and B2 and surface SS of solid raw material 120 to extend along the entirety. However, in the present specification, the expression "space is provided" has a broader meaning to indicate that the space has an average value exceeding zero. Hence, the expression may encompass the case where a space is provided between each of back-side surfaces B1 and B2 and surface SS of solid raw material 120 while there is partial contact therebetween. The following describes two modifications corresponding to this case.

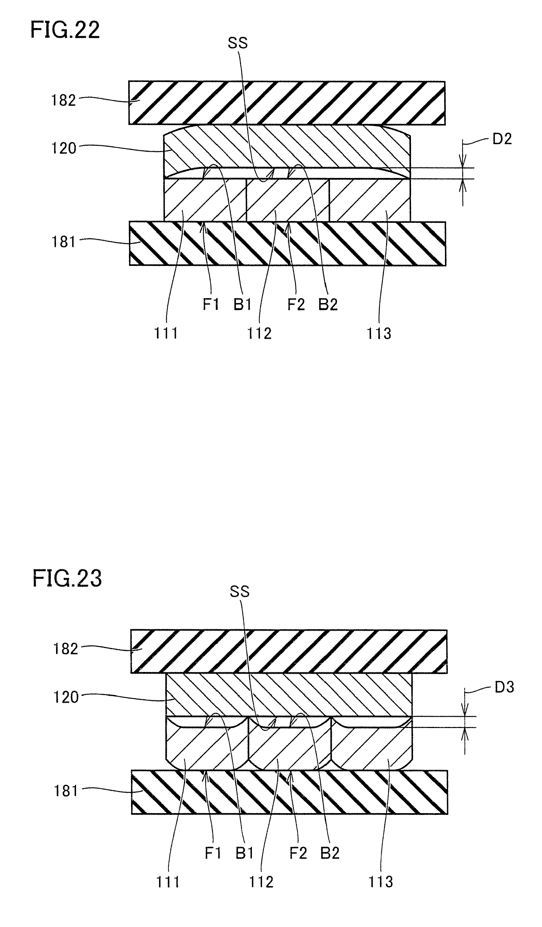

Referring to the modification of Fig. 22, the space is ensured by the warpage of the SiC wafer serving as solid raw material 120. More specifically, in the present modification, there is provided a space D2 that exceeds zero as an average value, but may be zero locally. Further preferably, as with the average value of space D1, the average value of space D2 is set to be smaller than the mean free path for the sublimation gas in the sublimation method. For example, the average value is not less than 1 µm and not more than 1 cm.

Referring to the modification of Fig. 23, the space is ensured by the warpage of each of SiC substrates 111-113. More specifically, in the present modification, there is provided a space D3 that exceeds zero as an average value, but may be zero locally. Further preferably, as with the average value of space D1, the average value of space D3 is set to be smaller than the mean free path for the sublimation gas in the sublimation method. For example, the average value is not less than 1 µm and not more than 1 cm.

In addition, the space may be ensured by combination of the respective methods shown in Fig. 22 and Fig. 23, i.e., by both the warpage of the SiC wafer serving as solid raw material 120 and the warpage of each of SiC substrates 111-113.

Each of the methods shown in Fig. 22 and Fig. 23 or the combination of these methods is particularly effective when the average value of the aforementioned space is not more than 100 µm.

Explained next are results of studying manufacturing conditions suitable for the manufacturing of semiconductor substrate 180 described above.

Reviewed first was each substrate temperature of SiC substrates 111, 112 in the formation of growth layer 130. It should be noted that pressure in the treatment chamber was reduced from the atmospheric pressure by exhausting air therefrom using a vacuum pump, and was maintained at 1Pa. Further, space D1 (Fig. 18) between each of back-side surfaces B1 and B2 and surface SS of solid raw material 120 was set at 50 µm. Furthermore, the temperatures of SiC substrates 111, 112 were set to be lower than the temperature of solid raw material 120 by 100°C. Results thereof are shown below.

**[Table 1]**

| 1600°C | 1800°C | 2000°C | 2500°C | 3000°C |
|---|---|---|---|---|
| Not Combined | Good | Good | Good | Decreased Crystallinity in Substrate |

From these results, it was found that in order to combine SiC substrates 111 and 112 with each other, the substrate temperature of 1600°C is too low and the substrate temperature of 1800°C or greater is preferable. It was also found that in order to avoid reduction in crystallinity in the substrates, the substrate temperature of 3000°C is too high and the substrate temperature of 2500°C or smaller is preferable. As such, it was found that the substrate temperature is preferably not less than 1800°C and not more than 2500°C.

Secondly, it was studied how low the temperature of each of SiC substrates 111, 112 should be set relative to the temperature of solid raw material 120, i.e., the difference in temperature therebetween. It should be noted that the pressure in the treatment chamber was reduced from the atmospheric pressure by exhausting air therefrom using the vacuum pump, and was maintained at 1 Pa. Further, the substrate temperature was fixed to 2000°C. Further, space D1 (Fig. 18) between each of back-side surfaces B1 and B2 and surface SS of solid raw material 120 was set at 50 µm. Results thereof are shown below.

**[Table 2]**

| 0.1°C | 1°C | 10°C | 100°C | 500°C |
|---|---|---|---|---|
| Small Growth Rate | Good | Good | Good | Large Distribution in Film Thickness |

From these results, it was found that in order to ensure sufficient growth rate of growth layer 130, the difference in temperature therebetween is too small when it is 0.1 °C, and is preferable when it is 1°C or more. It was also found that in order to suppress distributed film thickness of growth layer 130, the difference in temperature therebetween is too large when it is 500°C, and is preferable when it is 100°C or smaller. As such, it was found that the difference in temperature therebetween is preferably not less than 1°C and not more than 100°C.

Thirdly, the pressure of the atmosphere in the formation of growth layer 130 was studied. It should be noted that the above-described difference in temperature therebetween was set at 100°C. Further, the substrate temperature was fixed at 2000°C. Further, space D1 (Fig. 18) between each of back-side surfaces B1 and B2 and surface SS of solid raw material 120 was set at 50 ηm. Results thereof are shown below.

**[Table 3]**

| 100 kPa | 10 kPa | 1 kPa | 100 Pa | 1 Pa | 0.1 Pa |
|---|---|---|---|---|---|
| Not Combined | Low Strength in Combined Substrates | Good | Good | Good | Good |

From these results, it was found that in order to combine SiC substrates 111 and 112 with each other, the pressure is too high when it is 100 kPa, and is preferable when it is 50 kPa or lower, and is particularly preferable when it is 10 kPa or lower.

Fourthly, space D1 (Fig. 18) between each of back-side surfaces B1 and B2 and surface SS of solid raw material 120 was studied. It should be noted that the pressure in the treatment chamber was reduced from the atmospheric pressure by exhausting air therefrom using the vacuum pump, and was maintained at 1 Pa. Further, the substrate temperature was fixed at 2000°C. The above-described difference in temperature was set at 50°C.

As a result, when space D1 = 5 cm, distribution in film thickness of growth layer 130 was too large, while when space D1 = 1 cm, 1 mm, 500 µm, or 1 µm, distribution in film thickness of growth layer 130 could be set small enough. As such, it was found that in order to achieve sufficiently small distribution in the film thickness of growth layer 130, space D1 is preferably 1 cm or smaller.

It is considered that an appropriate value for space D1 is associated with the mean free path for the sublimation gas in the sublimation method. Specifically, it is considered preferable that the average value of space D1 be set smaller than this mean free path. For example, under the pressure of 1 Pa and the temperature of 2000°C, the mean free path of the atoms and molecules is present in approximately several to several ten centimeters, depending upon the atomic radius and molecular radius, strictly speaking. Therefore, in practice, the aforementioned distance is preferably set less than or equal to several centimeters.

Fifthly, the roughness of each of back-side surfaces B1 and B2 was studied. It should be noted that the pressure in atmosphere was set at 1 Pa and the substrate temperature was set at 2000°C. As a result, when roughness Ra was Ra = 500 µm, noticeable irregularities were generated at the surface of growth layer 130, while when Ra = 100 µm, 1 µm, or 0.1 nm, the irregularities were small enough. As such, it was found that in order to set irregularities small enough at the surface of growth layer 130, the roughness of each of back-side surfaces B1 and B2 is not more than 100 µm. In addition, in the case where each of back-side surfaces B1 and B2 was the so-called "as-sliced surface", the irregularities could be set small enough.

In addition, it was also confirmed that the following exemplary conditions can be adopted without any problem with the pressure in atmosphere being at 1 Pa and the substrate temperature being at 2000°C.

The duration for the formation of growth layer 130 could be one minute, one hour, three hours, or 24 hours. As the atmospheric gas, inactive gas atmosphere employing He, Ar, N₂, or N₂ of 60% concentration was available. Also, instead of the inactive gas atmosphere, atmosphere obtained by reducing the pressure of the atmospheric air was available. Further, solid raw material 120 (Fig. 18) could be used in the form of single crystal, polycrystal, sintered compact, or SiC powder. Furthermore, in the case where each of SiC substrates 111 and 112 has a plane orientation of (03-38), a plane orientation of (0001), (03-38), (11-20), or (1-100) was available for the plane orientation of surface SS (Fig. 18) of solid raw material 120. Further, as the impurity in solid raw material 120 (Fig. 18), nitrogen or phosphorus could be used at the concentration of 5 × 10¹⁵ cm⁻³, 8 × 10¹⁸ cm⁻³ or 5 × 10²¹ cm⁻³. Further, in the case where each of SiC substrates 111 and 112 has the polytype of 4H, the polytype of 4H, 6H, 15R, or 3C could be used as the polytype of solid raw material 120.

While embodiments and examples of the present invention have been described, it is initially intended that the features of each of the embodiments and examples may be combined appropriately. Further, it is to be understood that the embodiments and examples disclosed herein are by way of illustration in every respect, and not to be taken by way of limitation. The scope of the present invention is defined by the appended claims rather than by the description set forth above, and all changes that fall within limits and bounds of the claims, or equivalent of such metes and bounds are therefore intended to be embraced by the claims.

### REFERENCE SIGNS LIST

10a, 10b, 10c, 10d SiC ingot; 11 seed substrate; 11 a, 20a main surface; 12 crystal; 12a bottom face; 12b, 12c, 12d, 12e side face; 12f growth face; 17 raw material; 20 SiC substrate; 100 crucible; 100b outer circumferential face; 101 first portion; 101a, 102a inner circumferential face; 102 second portion; R1 first region; R2 second region; 111 SiC substrate (first silicon carbide substrate); 112 SiC substrate (second silicon carbide substrate); 113-119 SiC substrate; 120, 120p solid raw material; 130, 130p growth layer; 150 connecting portion; 180 semiconductor substrate; 181 first heating body; 182 second heating body.

## Claims

1. A silicon carbide ingot (10a, 10b, 10c, 10d) comprising:
a bottom face (12a) having four sides,
four side faces (12b, 12c, 12d, 12e) extending from said bottom face (12a) in a direction intersecting an extending direction of said bottom face (12a); and
a growth face (12f) connected with said side faces (12b, 12c, 12d, 12e), and located at a side opposite to said bottom face (12a).

2. The silicon carbide ingot (10a, 10b, 10c, 10d) according to claim 1, wherein at least one of said bottom face (12a), said side faces (12b, 12c, 12d, 12e), and said growth face (12f) is a {0001} plane, {1-100} plane, {11-20} plane, or a plane having an inclination within 10° relative to the {0001} plane, {1-100} plane, and {11-20} plane.

3. The silicon carbide ingot (10a, 10b, 10c, 10d) according to claim 1, further comprising a seed substrate (11) formed in contact with said bottom face (12a),
wherein a main surface (11a) of said seed substrate (11) in contact with said bottom face (12a) corresponds to a {0001} plane, or has an inclination within 10° relative to the {0001} plane.

4. A silicon carbide substrate (20), produced from a silicon carbide ingot (10a, 10b, 10c, 10d) defined in claim 1.

5. The silicon carbide substrate (20) according to claim 4, including a main surface (20a) having an off angle greater than or equal to 50° and less than or equal to 65° relative to a {0001} plane.

6. A crucible (100) comprising:
a first portion (101) forming a region in which a raw material (17) is disposed;
and
a second portion connected to said first portion (101), forming a region in which a seed substrate (11) is arranged, facing said raw material (17),
said second portion (102) having a cross sectional shape of a quadrilateral or chamfered quadrilateral.

7. The crucible (100) according to claim 6, wherein said first and second portions (101, 102) are made of graphite.

8. A method for manufacturing a silicon carbide ingot (10a, 10b, 10c, 10d) using a crucible (100) defined in claim 6, said method comprising the steps of:
disposing a raw material (17) in said first portion (101);
disposing a seed substrate (11) in said second portion (102); and
growing a silicon carbide ingot (10a, 10b, 10c, 10d) by sublimating said raw material (17) through heating to deposit raw material gas on said seed substrate (11).

9. The method for manufacturing a silicon carbide ingot (10a, 10b, 10c, 10d) according to claim 8, wherein at least one of each sides of said quadrilateral or chamfered quadrilateral of the cross sectional shape of said second portion (102) in said crucible (100) corresponds to a <0001> direction, <1-100> direction, <11-20> direction of said silicon carbide ingot (10a, 10b, 10c, 10d) grown in said growing step, or a direction having an inclination within 10° relative to the <0001> direction, <1-100> direction, and <11-20> direction.

10. A method for manufacturing a silicon carbide substrate (20) comprising the steps of:
manufacturing a silicon carbide ingot (10a, 10b, 10c, 10d) by the method for manufacturing a silicon carbide ingot defined in claim 8; and
slicing out a silicon carbide substrate (20) from said silicon carbide ingot (10a, 10b, 10c, 10d).

11. The method for manufacturing a silicon carbide substrate (20) according to claim 10, wherein, in said slicing step, said silicon carbide substrate (20) is sliced from said silicon carbide ingot (10a, 10b, 10c, 10d) using a wire saw.

12. A semiconductor substrate (180) obtained by aligning the silicon carbide substrate (20) defined in claim 4 in plurality on a same plane and connecting the substrates.
